# EUROPEAN PATENT APPLICATION

(11) **EP 4 227 862 A1**
(43) Date of publication of application: **16.08.2023**
(21) Application number: 21914541.4
(22) Date of filing: 29.12.2021
(51) Int. Cl.: G06N 10/00

(54) **SUPERCONDUCTING QUANTUM CHIP STRUCTURE AND SUPERCONDUCTING QUANTUM CHIP PREPARATION METHOD**

(30) Priority: 31.12.2020 CN 202011637469; 31.12.2020 CN 202011641465
(71) Applicant: Origin Quantum Computing Technology Co., Ltd., Hefei, Anhui 230088 (CN)
(72) Inventor: ZHAO, Yongjie, Hefei, Anhui 230088 (CN)
(74) Representative: Murgitroyd & Company
(86) International application number: PCT/CN2021/142676
(87) International publication number: WO 2022/143809

(57) **Abstract**

The present application discloses a superconducting quantum chip structure and a fabrication method for a superconducting quantum chip. The superconducting quantum chip structure includes a first structural member, a second structural member, and a support and connection member, where the first structural member is provided with a qubit, a read cavity, and a first connection terminal, the qubit is coupled to the read cavity, and the qubit is electrically connected to the first connection terminal; the second structural member is provided with a signal transmission line and a second connection terminal electrically connected to each other; and two ends of the support and connection member are electrically connected to the first connection terminal and the second connection terminal, respectively, and the support and connection member is configured to transmit a control signal received on the signal transmission line to the qubit. According to the technical solutions of the present application, a planar size of a superconducting quantum chip structure is reduced, and an integration degree of a multi-bit superconducting quantum chip is improved.

## Description

### CROSS-REFERENCE TO RELATED APPLICATIONS

This application claims priorities to Chinese Patent Application No. 202011637469.8, filed with the China National Intellectual Property Administration on December 31, 2020 and entitled "SUPERCONDUCTING QUANTUM CHIP STRUCTURE", and Chinese Patent Application No. 202011641465.7, filed with the China National Intellectual Property Administration on December 31, 2020 and entitled "PREPARATION METHOD FOR SUPERCONDUCTING QUANTUM CHIP", which are incorporated herein by reference in their entirety.

### TECHNICAL FIELD

The present application belongs to the field of quantum computing and chip fabrication technologies, and in particular, relates to a superconducting quantum chip structure and a fabrication method for a superconducting quantum chip.

### BACKGROUND

Quantum computers are physical apparatuses that perform high-speed mathematical and logical operations as well as store and process quantum information in accordance with the laws of quantum mechanics. The quantum computers mainly have advantages of high running speed, strong information handling capability, wide application range and the like. A core of a quantum computer is a quantum processor, which is also referred to as a superconducting quantum chip. For a classical integrated circuit chip, classical bits are constructed by using a plurality of transistors, a binary information unit is a classical bit, while for a superconducting quantum chip, different physical systems are used to construct qubits, for example, a superconducting quantum chip uses a Josephson junction to implement a two-level system. In a classical mechanics system, the state of one bit is unique, while quantum mechanics allows two states of a qubit to be superposed at a same moment, and in the quantum computing technology, two quantum states are superposed and entangled to perform operations based on qubits. The more qubits, the stronger the computing power of a quantum computer.

A superconducting quantum chip is provided with a qubit, a read cavity, a microwave line, a signal port, and the like, and these components are all integrated on a surface of a substrate. However, with the improvement of the computing power requirement of a quantum computer, a quantity of qubits is increasing, and a size of a superconducting quantum chip on which a two-dimensional structure is prepared on one substrate will be increasingly large, making integration difficult.

At present, how to prepare a superconducting quantum chip with a high integration degree becomes a technical problem to be solved urgently in the field.

### SUMMARY

The present application provides a superconducting quantum chip structure. The superconducting quantum chip structure can reduce a planar size of the superconducting quantum chip, and improve an integration degree of a multi-bit superconducting quantum chip, thereby at least solving a deficiency in the related art.

Some implementations of the present application provide a superconducting quantum chip structure in which a first structural member, a second structural member, and a support and connection member may be included. The first structural member is provided with a qubit, a read cavity, and a first connection terminal, the qubit is coupled to the read cavity, and the qubit is electrically connected to the first connection terminal. The second structural member is provided with a signal transmission line and a second connection terminal electrically connected to each other. Two ends of the support and connection member are electrically connected to the first connection terminal and the second connection terminal, respectively, and the support and connection member is configured to transmit a control signal received on the signal transmission line to the qubit.

Optionally, the qubit and the read cavity may be located on a first surface of the first structural member, the first connection terminal is located on a second surface of the first structural member, the first structural member is further provided with a first through hole penetrating through the first structural member from the first surface to the second surface of the first structural member, the first through hole is filled with a first metal layer, and the first metal layer is configured to electrically connect the qubit and the first connection terminal.

Optionally, the first connection terminal may be distributed on the second surface of the first structural member along a circumferential direction of the first through hole and may be coaxial with the first through hole.

Optionally, the qubit, the read cavity, and the first connection terminal may be all located on the second surface of the first structural member, the signal transmission line and the second connection terminal are located on a first surface of the second structural member, and the second surface of the first structural member is disposed opposite to the first surface of the second structural member.

Optionally, the qubit, the read cavity, and the first connection terminal may be all located on a second surface of the first structural member, and the second connection terminal is located on a first surface of the second structural member. The signal transmission line is located on a second surface of the second structural member, and the second structural member is provided with a second through hole penetrating through the first structural member from the first surface to the second surface of the second structural member. The second through hole is filled with a first metal layer, and the first metal layer is configured to electrically connect the second connection terminal and the signal transmission line.

Optionally, axial sections of the first through hole and the second through hole may be trapezoidal in shape.

Optionally, the first metal layer may be made of a superconducting material.

Optionally, the superconducting material may be titanium nitride, and a material of the support and connection member may be indium.

Optionally, a surface of the first metal layer may be filled with a protective film.

Optionally, the support and connection member may be cylindrical in shape.

Compared with the related art, the superconducting quantum chip structure of the present application may include a first structural member, a second structural member, and a support and connection member. The first structural member is provided with a qubit, a read cavity, and a first connection terminal, the qubit is coupled to the read cavity, and the qubit is electrically connected to the first connection terminal. The second structural member is provided with a signal transmission line and a second connection terminal electrically connected to each other. Two ends of the support and connection member are electrically connected to the first connection terminal and the second connection terminal, respectively, and the support and connection member is configured to transmit a control signal received on the signal transmission line to the qubit. The qubit, the read cavity, and the signal transmission line are disposed on different structural members, and the qubit disposed on the first structural member and the signal transmission line disposed on the second structural member are electrically connected by means of the first connection terminal, the second connection terminal, and the support and connection member, so that a complete superconducting quantum chip structure is formed, a planar size of the superconducting quantum chip is greatly reduced, and an integration degree of a multi-bit superconducting quantum chip is improved.

The present application further provides a fabrication method for a superconducting quantum chip, and based on the fabrication method for a superconducting quantum chip, a method for preparing a superconducting quantum chip having a three-dimensional structure and a high integration degree can be provided.

Some other implementations of the present application provide a fabrication method for a superconducting quantum chip, and the method may include:
forming a qubit, a read cavity, and a first connection terminal on a first structural member, where the qubit is coupled to the read cavity, and the qubit is electrically connected to the first connection terminal; forming a signal transmission line and a second connection terminal on a second structural member, where the signal transmission line and the second connection terminal are electrically connected; and forming a support and connection member, where two ends of the support and connection member are electrically connected to the first connection terminal and the second connection terminal, respectively, and the support and connection member is configured to transmit a control signal received on the signal transmission line to the qubit.

Optionally, the step of forming a qubit, a read cavity, and a first connection terminal on the first structural member may include: forming a first through hole penetrating through the first structural member from a first surface to a second surface of the first structural member; filling a first metal layer in the first through hole; forming the first connection terminal on the second surface of the first structural member; and forming the qubit and the read cavity on the first surface of the first structural member, where the first metal layer is configured to electrically connect the qubit and the first connection terminal.

Optionally, before the step of forming a first through hole penetrating through the first structural member from a first surface to a second surface of the first structural member, the method may include: forming a first protective film on the second surface of the first structural member.

Optionally, the step of forming a first through hole penetrating through the first structural member from a first surface to a second surface of the first structural member may include: performing etching on the first structural member by using an inductively coupled plasma to form the first through hole.

Optionally, the step of filling a first metal layer in the first through hole may include: forming the first metal layer in the first through hole by using an atomic layer deposition technology.

Optionally, after the step of forming the first metal layer in the first through hole by using an atomic layer deposition technology, a second protective film may be formed on a surface of the first metal layer

Optionally, the step of forming a qubit, a read cavity, and a first connection terminal on the first structural member may include: forming the qubit, the read cavity, and the first connection terminal on the second surface of the first structural member; and the step of forming a signal transmission line and a second connection terminal on a second structural member includes: forming the signal transmission line and the second connection terminal on a first surface of the second structural member, where the first surface and the second surface are disposed opposite to each other.

Optionally, the step of forming a signal transmission line and a second connection terminal on a second structural member may include: forming a second through hole penetrating through the second structural member from the first surface to a second surface of the second structural member; filling a second metal layer in the second through hole; forming the second connection terminal on the first surface of the second structural member; and forming the signal transmission line on the second surface of the second structural member, where the second metal layer is configured to electrically connect the signal transmission line and the second connection terminal.

Optionally, the step of forming a support and connection member, where two ends of the support and connection member are electrically connected to the first connection terminal and the second connection terminal respectively may include: forming the support and connection member on a surface of the second connection terminal; and electrically connecting the other end of the support and connection member to the first connection terminal.

Optionally, the step of electrically connecting the other end of the support and connection member to the first connection terminal may include: welding the other end of the support and connection member to the first connection terminal by using a flip-chip bonding technology.

Compared with the related art, in the present application, a qubit, a read cavity, and a first connection terminal are formed on a first structural member, where the qubit is coupled to the read cavity, and the qubit is electrically connected to the first connection terminal; a signal transmission line and a second connection terminal are formed on a second structural member, where the signal transmission line and the second connection terminal are electrically connected; and a support and connection member is formed, where two ends of the support and connection member are electrically connected to the first connection terminal and the second connection terminal, respectively, and the support and connection member is configured to transmit a control signal received on the signal transmission line to the qubit, thereby forming a complete circuit structure of a superconducting quantum chip. The present application provides a method for preparing a superconducting quantum chip with a high integration degree.

### BRIEF DESCRIPTION OF THE DRAWINGS

FIG. 1 is a structural diagram of a superconducting quantum chip of a two-dimensional structure in the related art.
FIG. 2 is a perspective structural diagram of a superconducting quantum chip according to the present application.
FIG. 3 is a flowchart of a fabrication method for a superconducting quantum chip according to the present application.
FIG. 4 is a structural diagram of an upper surface (a first surface) of a first structural member according to the present application.
FIG. 5 is a structural diagram of a lower surface (a second surface) of a first structural member according to the present application.
FIG. 6 is a structural diagram of an upper surface (a first surface) of a second structural member according to the present application.
FIG. 7 is a flowchart of a method for forming a first structural member according to the present application.
FIG. 8 is a schematic diagram of a structure in which a first through hole is formed according to the present application.
FIG. 9 is a schematic diagram of a structure in which a first metal layer is formed on a surface of a first through hole according to the present application.
FIG. 10 is a schematic diagram of a structure in which a second protective film is formed according to the present application.
FIG. 11 is a schematic diagram for removing a first protective film from a first structural member according to the present application.
FIG. 12 is a schematic diagram of an overall structure of a first structural member according to the present application.
FIG. 13 is a perspective structural diagram of a second superconducting quantum chip according to the present application.
FIG. 14 is a flowchart of a fabrication method for a second superconducting quantum chip according to the present application.
FIG. 15 is a schematic structural diagram of a second connection terminal of a second structural member according to the present application.
FIG. 16 is a schematic structural diagram of a signal transmission line of a second structural member according to the present application.
FIG. 17 is a perspective structural diagram of a third superconducting quantum chip according to the present application.
FIG. 18 is a flowchart of a fabrication method for a third superconducting quantum chip according to the present application.
FIG. 19 is a schematic structural diagram of a chip prepared by using a fabrication method for a third superconducting quantum chip according to the present application.
FIG. 20 is a schematic flowchart for forming a support and connection member according to the present application.
FIG. 21 is a schematic diagram of a structure in which a support and connection member is formed according to the present application.

Reference signs are as follows: 1. substrate, 11. qubit, 12. read cavity, 13. signal transmission line, 14. signal port, 10. first structural member, 20. second structural member, 30. support and connection member, 101. qubit, 102. read cavity, 103. first connection terminal, 104. first through hole, 105. first metal layer, 106. first protective film, 107. second protective film, 201. signal transmission line, 202. second connection terminal, 203. second metal layer, 204. second through hole, 205. third metal layer, and 206. third protective film.

### DETAILED DESCRIPTIONS OF THE EMBODIMENTS

The embodiments described below with reference to the accompanying drawings are exemplary and merely used to explain the present application, but cannot be understood as a limitation on the present application.

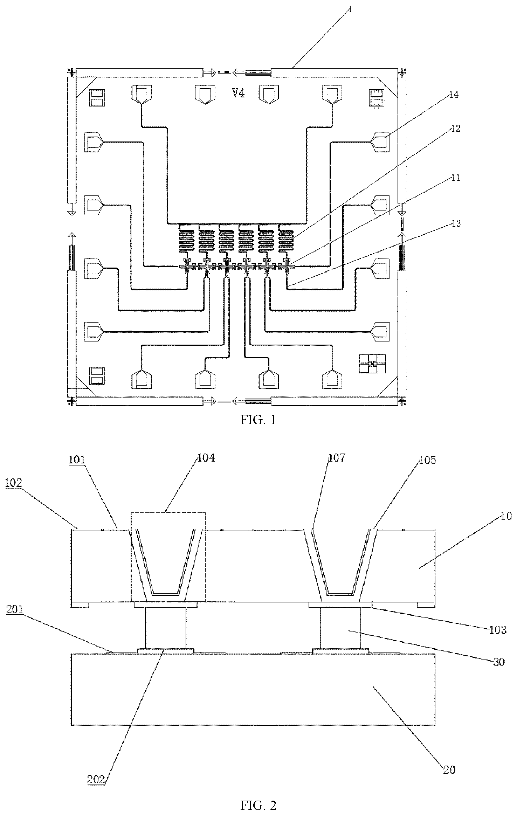

FIG. 1 is a diagram of a superconducting quantum chip structure, which is a two-dimensional structure commonly used at present, and specifically, a qubit 101 are prepared on a substrate 1 by using processes such as exposure, development, etching, and thin film deposition, a read cavity 12 for reading the qubit 11, a signal transmission line 13 for controlling the qubit 11, and a signal port for outputting signals of each qubit 11. Each qubit 11 corresponds to one circuit structure, and FIG. 1 only shows a 6-bit superconducting quantum chip. It may be imagined that when bits are raised to hundreds of bits, even thousands of bits, a quite large planar size of a superconducting quantum chip is required for integrating circuit structures of such many qubits 11 on a single substrate.

As shown in FIG. 2, the present application provides a superconducting quantum chip structure, and the superconducting quantum chip structure includes a first structural member 10, a second structural member 20, and a support and connection member 30. The first structural member 10 is provided with a qubit 101, a read cavity 102, and a first connection terminal 103, where the qubit 101 is coupled to the read cavity 102, and the qubit 101 is electrically connected to the first connection terminal 103. The second structural member 20 is provided with a signal transmission line 201 and a second connection terminal 202 electrically connected to each other. Two ends of the support and connection member 30 are electrically connected to the first connection terminal 103 and the second connection terminal 202, respectively, and the support and connection member is configured to transmit a control signal received on the signal transmission line 201 to the qubit 101. Thus, a complete superconducting quantum circuit is constructed.

The superconducting quantum chip includes the qubit 101 for operating quantum computing, the read cavity 102 for reading a quantum state of the qubit 101, the signal transmission line 201 for regulating and controlling the qubit 101, and a signal port for outputting a signal. In addition, a coupling structure may also be provided between adjacent qubits 101, that is, a large quantity of circuit structures and transmission lines are disposed on a superconducting quantum chip with a limited size. For a multi-bit superconducting quantum chip, integration is difficult, and when one of the qubits 101 is regulated and controlled, too dense transmission lines also cause signal crosstalk, thereby reducing performance of the superconducting quantum chip.

In an embodiment of the present application, the first structural member 10 may be a structure in which a substrate or wafer is used and the qubit 101, the read cavity 102, and the first connection terminal 103 are prepared on a surface of the substrate or wafer. Similarly, the second structural member 20 may be a structure in which a substrate or wafer is used and the signal transmission line 201 and the second connection terminal 202 are prepared on a surface of the substrate or wafer.

The embodiment of the present application provides a multi-layer superconducting quantum chip three-dimensional structure, which is used for disposing each circuit structure of a superconducting quantum chip in a layered manner. Specifically, the qubit 101 for operating quantum computing and the read cavity 102 are disposed on a first layer (namely, the first structural member 10), and the read cavity 102 needs to be coupled with the qubit 101 to read a quantum state of the qubit 101. Therefore, in order to ensure an effect of signal coupling, the read cavity 102 and the qubit 101 are disposed at a same layer and close to each other. In addition, the signal transmission line 201 for regulating and controlling a quantum state of the qubit 101 is disposed on a second layer (namely, the second structural member 20). Since this layer is used for disposing only the signal transmission line 201, reasonable planning may be performed during wiring, to reduce crosstalk between the signal transmission lines 201. For example, the signal transmission lines 201 corresponding to the qubit 101 with a relatively large frequency interval may be adjacently arranged based on a frequency parameter of the qubit 101, so as to reduce mutual influence between the signal transmission lines 201.

When the qubit 101 and the signal transmission line 201 are disposed at different layers, the first connection terminal 103 electrically connected to the qubit 101 is formed on the first structural member 10 and the second connection terminal 202 electrically connected to the signal transmission line 201 is formed on the second structural member 20, respectively. Further, the support and connection member 30 is disposed to position and support the first structural member 10 and the second structural member 20 that are disposed oppositely, and the first connection terminal 103 and the second connection terminal 202 are electrically connected to each other through both ends of the support and connection member 30, so that electrical connection between the qubit 101 and the signal transmission line 201 is implemented, thereby achieving a purpose of receiving a control signal through the signal transmission line 201 and regulating and controlling the qubit 101. In addition, the read cavity 102 is coupled to the qubit 101, and a quantum state of the qubit 101 may also be read through the signal transmission line 201, so that a circuit structure of the superconducting quantum chip is improved.

In the superconducting quantum chip structure of the present application, a first structural member 10, a second structural member 20, and a support and connection member 30 are provided. The first structural member 10 is provided with a qubit 101, a read cavity 102, and a first connection terminal 103, where the qubit 101 is coupled to the read cavity 102, and the qubit 101 is electrically connected to the first connection terminal 103; the second structural member 20 is provided with a signal transmission line 201 and a second connection terminal 202 electrically connected to each other; and two ends of the support and connection member 30 are electrically connected to the first connection terminal 103 and the second connection terminal 202, respectively, and the support and connection member 30 is configured to transmit a control signal received on the signal transmission line 201 to the qubit 101. The qubit 101, the read cavity 102, and the signal transmission line 201 are disposed on different structural members, and the qubit 101 disposed on the first structural member 10 and the signal transmission line 201 disposed on the second structural member 20 are electrically connected by means of the first connection terminal 103, the second connection terminal 202, and the support and connection member 30, so that a complete superconducting quantum chip structure is formed, a planar size of the superconducting quantum chip is significantly reduced, and an integration degree of a multi-bit superconducting quantum chip is improved.

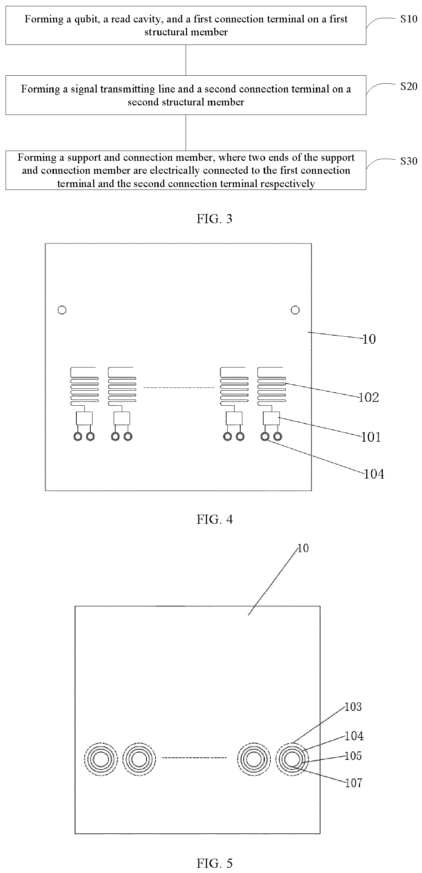

The present application further provides a fabrication method for a superconducting quantum chip corresponding to the foregoing superconducting quantum chip structure. FIG. 3 shows a method for forming the superconducting quantum chip, and the method may include the following steps.

Step S10: Forming a qubit 101, a read cavity 102, and a first connection terminal 103 on the first structural member 10, where the qubit 101 is coupled to the read cavity 102, and the qubit 101 is electrically connected to the first connection terminal 103.

Specifically, the qubit 101, the read cavity 102, and the first connection terminal 103 are first formed on the first structural member 10. The qubit 101 for operating quantum computing and the read cavity 102 are formed on a first layer (namely, the first structural member 10), where the read cavity 102 and the qubit 101 are coupled to implement reading of a quantum state of the qubit 101. Therefore, the read cavity 102 and the qubit 101 are disposed at a same layer and close to each other, which ensures an effect of signal coupling. In addition, the qubit 101 and the first connection terminal 103 need to be electrically connected, so that a part of a superconducting circuit structure (the qubit 101, the read cavity 102, and the first connection terminal 103) formed on the first structural member 10 are conductive, and the first connection terminal 103 is used as a connection medium of a circuit structure on the first structural member 10, and further electrically connected to a transmission line for transmitting a regulation and control signal formed on the second structural member 20.

Step S20: Forming a signal transmission line 201 and a second connection terminal 202 on the second structural member 20, where the signal transmission line 201 and the second connection terminal 202 are electrically connected.

Specifically, the signal transmission line 201 and the second connection terminal 202 that are electrically connected are formed on the second structural member 20, and the second connection terminal 202 serves as a connection medium of a circuit structure on the second structural member 20. The signal transmission line 201 for regulating and controlling a quantum state of the qubit 101 is formed on a second layer (namely, the second structural member 20). Since this layer is used for disposing only the signal transmission line 201, proper planning may be performed during wiring, to reduce crosstalk between the signal transmission lines 201. For example, the signal transmission lines 201 corresponding to the qubit 101 with a relatively large frequency interval may be adjacently arranged based on a frequency parameter of the qubit 101, so as to reduce mutual influence between the signal transmission lines 201.

Additionally, both the first structural member 10 and the second structural member 20 refer to a substrate for processing a superconducting quantum chip, and more specifically, a substrate of a semiconductor material, such as sapphire, silicon, and silicon carbide may be used.

Step S30: Forming a support and connection member, where two ends of the support and connection member are electrically connected to the first connection terminal 103 and the second connection terminal 202 respectively, and the support and connection member is configured to transmit a control signal received on the signal transmission line 201 to the qubit 101.

After the qubit 101 and the read cavity 102 are separately formed on the first structural member 10 and the first connection terminal 103 is used as a connection medium of the first structural member 10, a signal transmission line 201 is then formed on the second structural member 20, and the second connection terminal 202 is used as a connection medium of the second structural member 20, then the step of forming the support and connection member 30 is performed. The support and connection member 30 may be formed on a surface of the second connection terminal 202 by using an atomic layer deposition technology, and the support and connection member 30 is peeled off from the substrate. The support and connection member is not only configured to support the first structural member 10 and the second structural member 20, but also configured to electrically connect the first connection terminal 103 and the second connection terminal 202. In addition, the support and connection member is configured to transmit a control signal received on the signal transmission line 201 to the qubit 101.

In the present application, a qubit 101 and a read cavity 102 are formed on a first structural member 10, and a signal transmission line 201 is formed on a second structural member 20; a circuit structure (the qubit 101 and the read cavity 102) of a superconducting quantum chip for implementing quantum computing and a signal transmission line 201 for implementing control and regulation of the qubit 101 are layered and separately formed; and a first connection terminal 103 electrically connected to the qubit 101 is formed on the first structural member 10 and a second connection terminal 202 electrically connected to the signal transmission line 201 is formed on the second structural member 20, then a support and connection member 30 is formed, and two ends of the support and connection member 30 are electrically connected to the first connection terminal 103 and the second connection terminal 202, respectively. In this way, the control signal received on the signal transmission line 201 is transmitted to the qubit 101, thereby forming a complete circuit structure of a superconducting quantum chip. The superconducting quantum chip prepared by using the method in the present application has a high integration degree.

Next, embodiment 1 of a superconducting quantum chip structure according to the present application will be described in detail with reference to the accompanying drawings.

As shown in FIG. 2, this embodiment provides a superconducting quantum chip structure. Specifically, the qubit 101 and the read cavity 102 are located on a first surface of the first structural member 10, the first connection terminal 103 is located on a second surface of the first structural member 10, the first structural member 10 is further provided with a first through hole 104 penetrating through the first structural member 10 from the first surface to a second surface of the first structural member 10, the first through hole 104 is filled with a first metal layer 105, and the first metal layer 105 is configured to electrically connect the qubit 101 and the first connection terminal 103.

Since the first structural member 10 and the second structural member 20 are both double-sided in structure and arranged in parallel, and also supported and positioned by using the support and connection member 30, the first surface (namely, an upper surface) and the second surface (namely, a lower surface) of both the first structural member 10 and the second structural member 20 maybe provided with a superconducting quantum circuit. In this embodiment, the qubit 101 and the read cavity 102 are disposed on the first surface of the first structural member 10, and the first surface of the first structural member is away from the second structural member 20. In this way, a vertical distance from the qubit 101 and the read cavity 102 to the signal transmission line 201 on the second layer (namely, the second structural member 20) may be increased, thereby further reducing an impact, on another qubit 101, of a control signal applied by the signal transmission line 201.

The first through hole 104 is provided on the first structural member 10, the first through hole 104 communicates the first surface and the second surface of the first structural member 10, the first connection terminal 103 is disposed at a position, where the first through hole 104 is located, on the second surface of the first structural member 10, and the first metal layer 105 is filled in the first through hole, and electrical connection between the qubit 101 on the first surface of the first structural member 10 and the first connection terminal 103 on the second surface of the first structural member 10 is implemented by means of conductivity of the first metal layer 105.

In addition, the second connection terminal 202 and the signal transmission line 201 that are electrically connected are disposed on the first surface of the second structural member 20, and a support and connection member 30 is disposed between the first structural member 10 and the second structural member 20, and the first structural member 10 and the second structural member 20 are supported and positioned by using the support and connection member 30, so that the first connection terminal 103 and the second connection terminal 202 are electrically connected. That is, electrical connection between the signal transmission line 201 and the qubit 101 is implemented through the second connection terminal 202, the support and connection member 30, the first connection terminal 103, and the first through hole 104, thereby achieving an effect of designing the superconducting quantum chip structure in a layered manner.

As shown in FIG. 2 and FIG. 5, when the first connection terminal 103 is disposed on the second surface of the first structural member 10, the first connection terminal 103 is distributed on the second surface of the first structural member 10 along a circumferential direction of the first through hole 104, and the first connection terminal 103 and the first through hole 104 are coaxially disposed. In addition, the second connection terminal 202 is disposed at a position, corresponding to the first connection terminal 103, on the first surface of the second structural member 20. The first structural member 10 is disposed directly above the second structural member 20 and parallel to the second structural member 20, so as to form a structure in which the first through hole 104, the first connection terminal 103, and the second connection terminal 202 are coaxially arranged. When the first connection terminal 103 of the first structural member 10 and the second connection terminal 202 of the second structural member 20 are prepared, a same processing flow may be used, thereby simplifying a process. In addition, when the first structural member 10 and the second structural member 20 are positioned by using the support and connection member 30, alignment of the first connection terminal 103, the second connection terminal 202, and the first through hole 104 may be easily implemented, thereby ensuring consistency of circuits of all qubits 101 on a superconducting quantum chip.

Still referring to FIG. 4 and FIG. 5, a first regulation and control signal for regulating and controlling a frequency parameter and a second regulation and control signal for regulating and controlling a quantum state parameter need to be applied to each of the qubits 101 on the superconducting quantum chip, and the first regulation and control signal and the second regulation and control signal need to be applied through different signal transmission lines. That is, each of the qubits 101 needs to be provided with two corresponding signal transmission paths, and the two signal transmission paths are isolated from each other, and each of the signal transmission paths needs to form an electrically connected signal conduction path through one first through hole 104, one first connection terminal 103, one second connection terminal 202, one support and connection member 30, and one second connection terminal 202 to construct a circuit structure for regulating and controlling a frequency parameter or a quantum state parameter of the qubit 101. In a specific implementation, as shown in the structural diagram of the first surface of the first structural member shown in FIG. 4, each qubit is electrically connected to the first metal layers 105 in the two first through holes 104, and the first metal layers 105 in the two first through holes 104 are respectively connected to the two first connection terminals 103 located on the second surface of the first structural member 10. Therefore, each of the first connection terminals 103 is electrically connected to one support and connection member 30, and the other end of the support and connection member 30 is electrically connected to the second connection terminal 202 on the first surface of the second structural member 20. One second connection terminal 202 is connected to one corresponding signal transmission line 201, and one signal transmission line 201 receives one first regulation and control signal or one second regulation and control signal.

Briefly, each of the qubits 101 is correspondingly provided with two first through holes 104, two first connection terminals 103, two support and connection members 30, two second connection terminals 202, and two signal transmission lines 201.

The following describes embodiment 1 of a fabrication method for a superconducting quantum chip according to the present application and corresponding to the embodiment 1 of the superconducting quantum chip structure in detail with reference to the accompanying drawings.

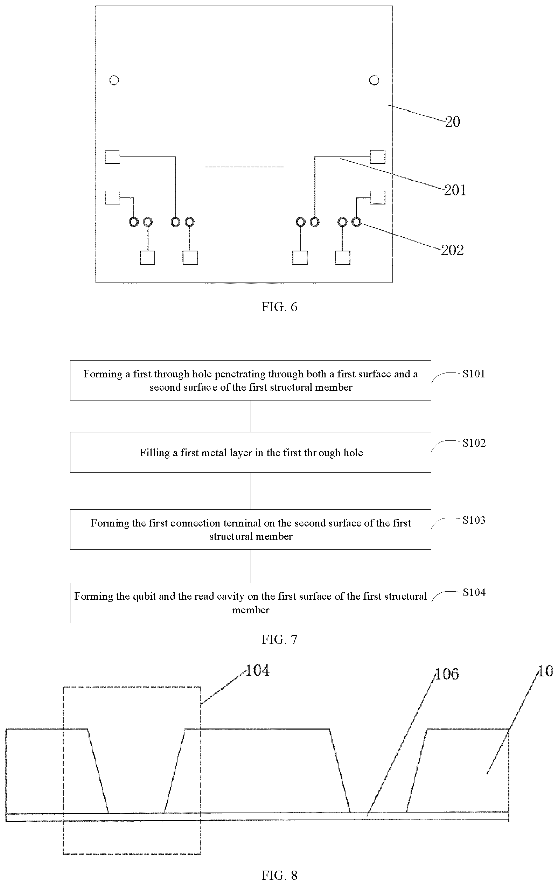

As shown in FIG. 7, the step of forming the qubit 101, the read cavity 102, and the first connection terminal 103 on the first structural member 10 includes the following step.

S101: Forming a first through hole 104 penetrating through the first structural member from a first surface to a second surface of the first structural member 10.

As shown in FIG. 8, the first structural member 10 is a double-sided substrate, and both the first surface and the second surface may be provided with a circuit structure. Specifically, the first surface refers to a horizontally upward facing surface of a substrate, and the second surface refers to a horizontally downward facing surface of the substrate. A substrate forming a superconducting quantum chip is usually made of a material such as sapphire and silicon, and therefore, the first surface and the second surface of the first structural member 10 are isolated. The first through hole 104 penetrating through the first structural member 10 from the first surface to the second surface is formed on the first structural member 10, so that the first surface and the second surface of the first structural member 10 may be communicated, thereby facilitating arrangement of a circuit structure of the superconducting quantum chip on both surfaces.

Additionally, an axial section of the first through hole 104 is trapezoidal in shape. Setting the axial section of the first through hole 104 to be trapezoidal in shape may facilitate formation of a conductive layer on a surface of the first through hole 104. Specifically, to form the conductive layer on the surface of the first through hole 104, metal particles are sprayed onto the surface of the first through hole 104 by using a spray gun. The trapezoidal shape is used, so that the metal particles may be deposited at all positions on the surface of the first through hole 104, and a conductive layer formed after deposition of the metal particles is more uniform.

Before the step of forming a first through hole 104 penetrating through the first structural member from a first surface to a second surface of the first structural member 10, a first protective film 106 needs to be formed on the second surface of the first structural member 10.

As shown in FIG. 8, in a specific implementation of the present application, for some of the processing processes, reference may alternatively be made to the processing flow of a semiconductor chip. The first through hole 104 penetrating through the first structural member 10 from the first surface to the second surface of the first structural member 10 is formed by using an etching process. Specifically, the first through hole 104 penetrating through the first structural member 10 from the first surface to the second surface of the first structural member 10 is formed by performing etching on the first surface of the first structural member 10. Therefore, before etching is performed, the first through hole 104 is patterned on the first surface of the first structural member 10, thereby ensuring that a shape and a size for the etching respectively conform to a desired shape and a desired size. In addition, a first protective film 106 is formed on the second surface of the first structural member 10, thereby preventing the second surface of the first structural member 10 from being polluted when etching is performed on the first surface of the first structural member 10. Specifically, the first protective film 106 may be a silicon dioxide thin film, and the first protective film 106 may be formed on the second surface of the first structural member 10 by using an electron beam evaporation coating technology.

In the present application, during formation of the first through hole 104 penetrating through the first structural member 10 from the first surface to the second surface of the first structural member 10, the first through hole 104 may be formed by performing etching on the first structure member 10 by using inductively coupled plasma technology.

In a chip processing flow, an etching method for a substrate include physical bombardment etching and chemical reaction etching. Specifically, the physical bombardment etching may include ion beam etching, and the chemical reaction etching may include inductively coupled plasma etching. In contrast, chemical reaction etching is generally used to make deep silicon etching. In the present application, the first through hole 104 that needs to etch penetrates through the first structural member from the first surface to the second surface of the first structural member 10, that is, the first through hole 104 that needs to etch in the present application is a relatively deep hole. Therefore, chemical reaction etching, namely, inductively coupled plasma etching is used. In this way, it may be ensured that a depth-to-width ratio of the first through hole 104 is better.

S102: Filling the first through hole 104 with a first metal layer 105.

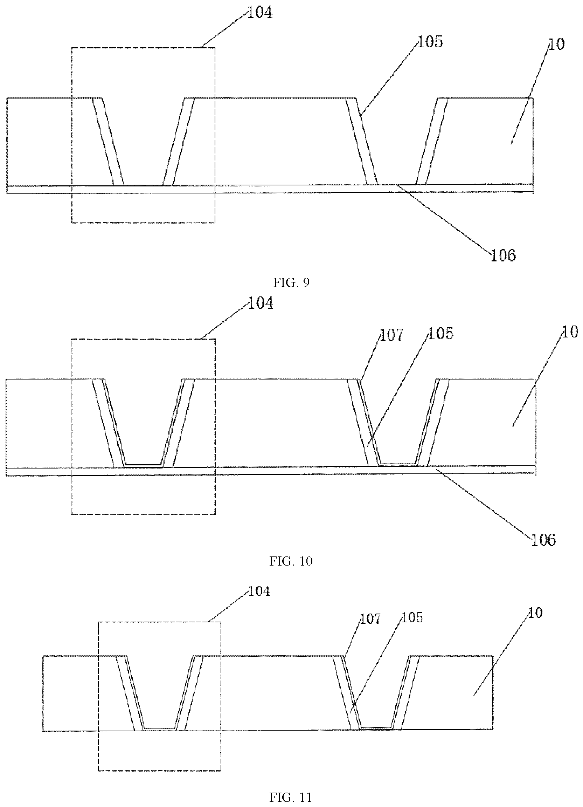

As shown in FIG. 9, the first through hole 104 penetrates through the first structural member from the first surface to the second surface of the first structural member 10, and in order to electrically connect circuit structures on the two surfaces of the first structural member 10, a conductive layer (namely, the first metal layer 105) needs to be further filled in the first through hole 104, so that electrical connection may be implemented between the first surface and the second surface of the first structural member 10 by means of electrical conductivity of the first metal layer 105, thereby forming electrical connection between the circuit structures of the two surfaces when the circuit structures are formed on the first surface and the second surface.

After the first through hole 104 is formed by using inductively coupled plasma etching, the step of filling the first through hole 104 with the first metal layer 105 further needs to be performed, including: forming the first metal layer 105 in the first through hole 104 by using an atomic layer deposition technology.

The first metal layer 105 electrically connects the qubit 101 and the first connection terminal 103. A requirement for precision of a signal by the superconducting quantum chip is relatively high, and thus performance of a circuit structure in the superconducting quantum chip needs to be ensured, especially performance of some structures that implement electrical connection (such as the first metal layer 105, and the support and connection member 30). For the atomic layer deposition technology, deposition parameters (thickness, composition, structure) have a high controllability, so that uniformity and consistency of the first metal layer 105 formed by depositing a first metal on the surface of the first through hole 104 by using an atomic layer deposition technology are ensured, thereby helping to ensure better performance and better consistency of the superconducting quantum chip.

After the first metal layer 105 is formed in the first through hole 104 by using an atomic layer deposition technology, a second protective film 107 needs to be formed on the surface of the first metal layer 105.

As shown in FIG. 10, the first metal layer 105 is a conductive layer formed by using an atomic layer deposition technology on the surface of the first through hole 104 for electrically connecting the qubit 101 and the first connection terminal 103. In the processing process of the superconducting quantum chip of the present application, the first through hole 104 is first formed, and then the first metal layer 105 is formed on the inner surface of the first through hole 104 by using an atomic layer deposition technology. Then, the circuit structure of the qubit 101, the read cavity 102, and the first connection terminal 103 are formed on the first structural member 10, and then two ends of the support and connection member 30 are fastened to the first structural member 10 and the second structural member 20, respectively. It may be found that after a first metal film is deposited on the surface of the first through hole 104 by using an atomic layer deposition technology, there are a plurality of subsequent processes. When one layer of protective film (namely, the second protective film 107) is formed on the surface of the first metal layer 105, the first metal layer 105 may be effectively prevented from being oxidized, falling off, and the like, thereby ensuring conductivity of the first metal layer 105. Specifically, a material of the second protective film 107 is preferably selected as poly-p-xylene.

As shown in FIG. 11, after the second protective film 107 is formed on the surface of the first through hole, in order to facilitate forming a corresponding circuit structure on the second surface of the first structural member 10 in the subsequent step, the first protective film 106 formed on the second surface of the first structural member 10 needs to be removed first. Specifically, the silicon dioxide thin film (namely, the first protective film 106) is removed by wet etching.

S103: Forming the first connection terminal 103 on the second surface of the first structural member 10.

As shown in FIG. 5, the first connection terminal 103 may be formed on the second surface of the first structural member 10 by using an atomic layer deposition technology. In addition, during formation of the first connection terminal 103, the first connection terminal 103 is distributed on the second surface of the first structural member 10 along a circumferential direction of the first through hole 104, and the first connection terminal 103 and the first through hole 104 are coaxially disposed. In addition, the first connection terminal 103 is electrically connected to the first metal layer 105 filled in the first through hole 104. Therefore, it can be ensured that the support and connection member 30 and the first connection terminal 103 are easily aligned during electrical connection, and consistency is ensured.

S104: Forming the qubit 101 and the read cavity 102 on the first surface of the first structural member 10.

As shown in FIG. 4, in the circuit structure of the superconducting quantum chip, the qubit 101 is a core structure for quantum computing, and the read cavity 102 is a microwave resonator for reading a quantum state of the qubit 101. The read cavity 102 needs to be adjacent to the qubit 101, and thus the qubit 101 and the read cavity 102 are disposed on a same surface (namely, the first surface) of the first structural member 10 and the first connection terminal 103 is disposed on the other surface of the first structural member 10 (namely, the second surface). During formation of the qubit 101, the qubit 101 needs to be electrically connected to the first metal layer 105 disposed in the first through hole 104, and then the qubit 101 and the first connection terminal 103 are electrically connected through the first metal layer 105, that is, the purpose of communicating the read cavity 102, the qubit 101, and the first connection terminal 103 is achieved. In addition, the first connection terminal 103 serves as a connection medium of the first structural member 10 to be electrically connected to the second connection terminal 202 on the second structural member 20.

During formation of the qubit 101 and the read cavity 102 on the first surface of the first structural member 10, circuit shapes of the qubit 101 and the read cavity 102 are formed into a patterned mask by using an ultraviolet lithography technology, and a pattern structure is a specific circuit structure of the qubit 101 and the read cavity 102. Then, a metal of a superconducting material is deposited in the patterned mask by using an electron beam evaporation coating technology to obtain the circuit structure of the qubit 101 and the read cavity 102. Specifically, aluminum, niobium, tantalum, nitride of niobium and titanium, or the like may be selected, and the material of aluminum is preferably selected in the present application, which has a low cost and is easy to form.

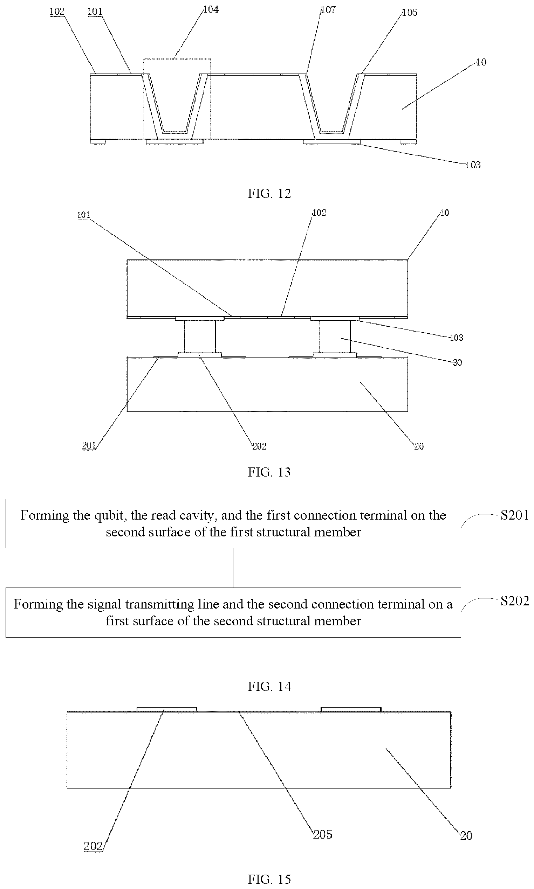

As shown in FIG. 12, a circuit structure needs to be formed on each of the first surface and the second surface of the first structural member 10, and the circuit structure of the qubit 101 and the read cavity 102 is more fragile relative to the first connection terminal 103, and thus a process needs to be strictly controlled during the formation. Therefore, during the formation of the circuit structure on the first structural member 10, Step S103 is performed first (namely, first forming the first connection terminal), and then Step S104 is performed (then forming the qubit 101 and the read cavity). If Step S104 is performed before Step S103, the circuit structure of the qubit 101 and the read cavity 102 is easily damaged during formation of the first connection terminal 103.

As shown in FIG. 6, after the qubit 101, the read cavity 102, and the first connection terminal 103 are formed on the first structural member 10 by using the foregoing steps, the formation of the first structural member 10 is initially completed. Then, the signal transmission line 201 and the second connection terminal 202 that are electrically connected are formed on the second structural member 20, and the first connection terminal 103 and the second connection terminal 202 are electrically connected by means of the support and connection member 30 to form a complete superconducting quantum chip structure.

As shown in FIG. 2, a first superconducting quantum chip structure prepared by using the fabrication method in this embodiment includes a first structural member 10, a second structural member 20, and a support and connection member 30. A qubit 101, a read cavity 102, and a first connection terminal 103 are formed on the first structural member 10, where the qubit 101 is coupled to the read cavity 102, and the qubit 101 is electrically connected to the first connection terminal 103; a signal transmission line 201 and a second connection terminal 202 electrically connected to each other are formed on the second structural member 20; and two ends of the support and connection member 30 are electrically connected to the first connection terminal 103 and the second connection terminal 202, respectively, and the support and connection member is configured to transmit a control signal received on the signal transmission line 201 to the qubit 101. Thus, a complete superconducting quantum circuit is constructed.

When the qubit 101 and the signal transmission line 201 are disposed at different layers, electrical connection between the first connection terminal 103 and the qubit 101 is formed on the first structural member 10 and electrical connection between the second connection terminal 202 and the signal transmission line 201 is formed on the second structural member 20. Further, the support and connection member 30 is used to support and position the first structural member 10 and the second structural member 20 that are oppositely disposed, and the first connection terminal 103 and the second connection terminal 202 are electrically connected to each other by using both ends of the support and connection member 30, so that electrical connection between the qubit 101 and the signal transmission line 201 is implemented, thereby achieving a purpose of receiving a control signal through the signal transmission line 201 and regulating and controlling the qubit 101. In addition, the read cavity 102 is coupled to the qubit 101, and may also read a quantum state of the qubit 101 through the signal transmission line 201, so that a circuit structure of the superconducting quantum chip is improved.

It should be noted that, a first regulation and control signal for regulating and controlling a frequency parameter and a second regulation and control signal for regulating and controlling a quantum state parameter need to be applied to each of the qubits 101 on the superconducting quantum chip, and the first regulation and control signal and the second regulation and control signal need to be applied through different signal transmission lines 201. That is, each of the qubits 101 needs to be provided with corresponding two paths of signal transmission lines, the two paths of signal transmission lines 201 are isolated from each other, and for each of the signal transmission paths, an electrically connected signal conduction path needs to be formed through one first through hole 104, one first connection terminal 103, one second connection terminal 202, one support and connection member 30, and one second connection terminal 202 to construct a circuit structure for regulating and controlling a frequency parameter or a quantum state parameter of the qubit 101.

In a specific implementation, as shown in the structural diagram of the first surface of the first structural member 10 shown in FIG. 4, each of the qubits 101 is electrically connected to the first metal layer 105 on the inner surface of the two first through holes 104. As shown in the structural diagram of the second surface of the first structural member 10 shown in FIG. 5, the first metal layer 105 on the inner surface of the first through hole 104 is connected to the first connection terminal 103 on the second surface of the first structural member 10; and then each first connection terminal 103 is electrically connected to one support and connection member 30. As shown in the structural diagram of the first surface of the second structural member 20 shown in FIG. 6, the other end of the support and connection member 30 is electrically connected to the second connection terminal 202 on the first surface of the second structural member 20, and is finally connected to one corresponding signal transmission line 201 to receive one first regulation signal or second regulation signal, and the support and connection member 30 and the second connection terminals 202 are coaxially disposed.

Briefly, a structure electrically connected to each of the qubits 101 directly or indirectly includes two first through holes 104, two first connection terminals 103, two support and connection members 30, two second connection terminals 202, and two signal transmission lines 201.

Embodiment 2 of a superconducting quantum chip structure according to the present application will be described in detail below with reference to the accompanying drawings.

Embodiment 2 of a superconducting quantum chip structure is illustrated in FIG. 13. This embodiment provides a second superconducting quantum chip structure. The qubit 101, the read cavity 102, and the first connection terminal 103 are all located on the second surface of the first structural member 10, the signal transmission line 201 and the second connection terminal 202 are located on the first surface of the second structural member 20, and the second surface of the first structural member 10 is disposed opposite to the first surface of the second structural member 20.

Specifically, the superconducting quantum chip structure includes the first structural member 10 and the second structural member 20 that are disposed in parallel, and the qubit 101 and the read cavity 102 are disposed on the second surface of the first structural member 10. In addition, the signal transmission line 201 is disposed on the first surface of the second structural member 20, so as to implement symmetrical arrangement, the first structural member 10 and the second structural member 20 are supported by a support and connection member 30, and the first connection terminal 103 and the second connection terminal 202 are electrically connected through two ends of the support and connection member 30 respectively, to implement connection of a superconducting quantum circuit.

In this embodiment, the qubit 101, the read cavity 102, and the signal transmission line 201 are symmetrically disposed along the second surface of the first structural member 10 and the first surface of the second structural member 20 by using a support and connection member 30. Moreover, a distance between the qubit 101 and the signal transmission line 201 is widened by using the support and connection member 30, and the first through hole 104 does not need to be disposed on the first structural member 10. In this way, a crosstalk impact of a regulation and control signal applied to the signal transmission line 201 on the qubit 101 may be reduced, and a three-dimensional structure of a superconducting quantum chip is implemented, thereby significantly improving an integration degree and performance of the superconducting quantum chip.

Next, embodiment 2 of a fabrication method for a superconducting quantum chip according to the present application and corresponding to the embodiment 2 of the superconducting quantum chip structure is described in detail with reference to the accompanying drawings.

As shown in FIG. 14, the steps of forming a qubit 101, a read cavity 102, and a first connection terminal 103 on the first structural member 10, and forming a signal transmission line 201 and a second connection terminal 202 on the second structural member 20 include the following steps.

Sill: Forming the qubit 101, the read cavity 102, and the first connection terminal 103 on the second surface of the first structural member 10.

Different from the step of forming the qubit 101, the read cavity 102, and the first connection terminal 103 on the first structural member 10 in method embodiment 1, in method embodiment 2, the qubit 101, the read cavity 102, and the first connection terminal 103 are all processed on a same surface (namely, the second surface) of the first substrate. A specific process method for preparing the qubit 101, the read cavity 102, and the first connection terminal 103 is the same as that in the method embodiment 1, and details are not described herein.

Step 5112: Forming the signal transmission line 201 and the second connection terminal 202 on the first surface of the second structural member 20, where the first surface and the second surface are disposed opposite to each other.

The signal transmission line 201 and the second connection terminal 202 are formed on a same surface of the second structural member 20, namely, the first surface opposite to the second surface of the first structural member 10, so that the second connection terminal 202 and the first connection terminal 103 are disposed opposite to each other, In this way, the support and connection member 30 formed on the second connection terminal 202 is easily fastened to the first connection terminal 103.

Specifically, during formation of the second connection terminal 202 on the first surface of the second structural member 20, a process same as that in Step S103 (preparing the first connection terminal 103 on the second surface of the first structural member 10) is used; and during formation of the signal transmission line 201 on the first surface of the second structural member 20, processes commonly used in the current chip fabrication field are used, that is, processes such as exposure, development, etching, and cleaning.

As shown in FIG. 15, during formation of the signal transmission line 201 and the second connection terminal 202 on the surface of the second structural member 20, one conductive layer (namely, a third metal layer 205) needs to be first formed on a surface of the second structural member by using an atomic layer deposition technology. Since materials of the second structural member 20 are all semiconductor materials, when the signal transmission line 201 is in a form of a microstrip transmission line, the signal transmission line 201 cannot be prepared directly on the surface of the second structural member 20. First, the third metal layer 205 is formed on the first surface of the second structural member 20, then the signal transmission line 201 is prepared on a surface of the third metal layer 205 by using a patterning process such as photolithography, and the signal transmission line 201 and the second connection terminal 202 may be electrically connected by means of the third metal layer 205. A material of the third metal layer 205 may be a superconducting material, and specifically, the material of the third metal layer 205 may be aluminum.

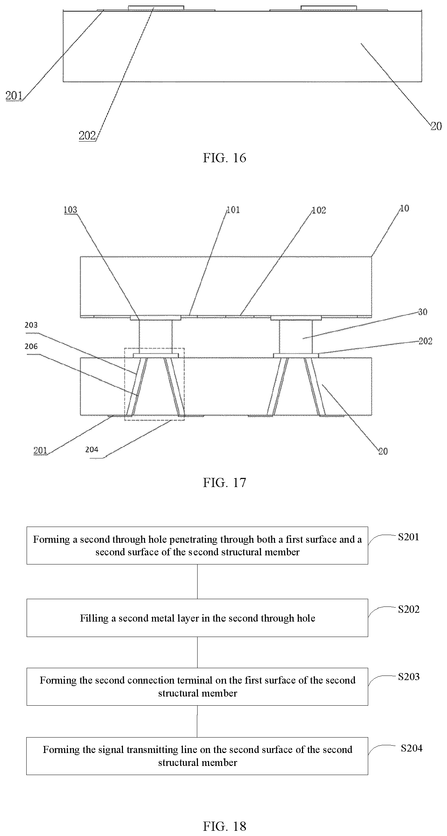

In addition, as shown in FIG. 16, after the signal transmission line 201 is formed on the third metal layer 205, the third metal layer 205 except for the signal transmission line 201 needs to be removed, so that only a circuit structure corresponding to the signal transmission line 201 and the second connection terminal 202 is formed on the first surface of the second structural member 20.

As shown in FIG. 13, FIG. 13 shows a second superconducting quantum chip structure prepared according to the method provided in this embodiment. The superconducting quantum chip structure includes the first structural member 10 and the second structural member 20, and the qubit 101, the read cavity 102, and the first connection terminal 103 are formed on the second surface of the first structural member 10. In addition, the signal transmission line 201 and the second connection terminal 202 are disposed on the first surface of the second structural member 20, so as to implement symmetrical arrangement, the first structural member 10 and the second structural member 20 are supported by a support and connection member 30, and the first connection terminal 103 and the second connection terminal 202 are electrically connected through two ends of the support and connection member 30 respectively, to implement connection of a superconducting quantum circuit.

In this embodiment, the qubit 101, the read cavity 102, and the signal transmission line 201 are symmetrically disposed along the second surface of the first structural member 10 and the first surface of the second structural member 20 by using a support and connection member 30. Moreover, a distance between the qubit 101 and the signal transmission line 201 is widened by using the support and connection member 30, and the first through hole 104 does not need to be disposed on the first structural member 10. In this way, a crosstalk impact of a regulation and control signal applied to the signal transmission line 201 on the qubit 101 may be reduced, and a three-dimensional structure of a superconducting quantum chip is implemented, thereby significantly improving an integration degree and performance of the superconducting quantum chip.

Embodiment 3 of a superconducting quantum chip structure according to the present application will be described in detail below with reference to the accompanying drawings.

A shown in FIG. 17, this embodiment provides a third superconducting quantum chip structure. The qubit 101, the read cavity 102, and the first connection terminal 103 may be all located on a second surface of the first structural member 10, the second connection terminal 202 may be located on a first surface of the second structural member 20, the signal transmission line 201 may be located on a second surface of the second structural member 20 and the second structural member 20 is provided with a second through hole 204 penetrating through the second structural member 20 from the first surface to the second surface of the second structural member 20, the second through hole 204 is filled with a first metal layer 105, and the first metal layer 105 is configured to electrically connect the second connection terminal 202 and the signal transmission line 201.

Compared with the structural embodiment 2, in this embodiment, the second connection terminal 202 of the second structural member 20 is disposed on the first surface of the second structural member 20, the signal transmission line 201 is disposed on the second surface of the second structural member 20, and the second through hole 204 penetrating through the second structural member 20 from the first surface to the second surface of the second structural member 20 is disposed. Further, a second metal layer 203 is formed in the second through hole 204, so that the second connection terminal 202 and the signal transmission line 201 are connected by means of conductivity of the second metal layer 203. By means of this structural design, a distance between the signal transmission line 201 and the qubit 101 is increased, and crosstalk of a superconducting quantum circuit is weakened to a negligible extent by using an insulating effect of the second structural member 20 itself.

It should be noted that, in the chip fabrication field, especially in the superconducting quantum chip fabrication field, a material of a substrate is generally sapphire, silicon, silicon carbide, or the like, and these materials themselves have an insulating effect. Therefore, in the foregoing three structure embodiments, the superconducting quantum chip structures in the structure embodiment 1 and structure embodiment 3 are preferably selected. The qubit 101 is isolated from the signal transmission lines 201 by using insulating properties of materials of the first structural member 10 and the second structural member 20, and the first structural member 10 is isolated from the second structural member 20 in layers by means of a support and connection member 30, significantly reducing a crosstalk impact of a control signal applied to the signal transmission line 201 on another qubit 101.

More optionally, in structure embodiment 1 and structure embodiment 3, a superconducting quantum chip structure in embodiment 1 is preferably selected. That is, the qubit 101 and the read cavity 102 are disposed on the first surface of the first structural member 10, the first connection terminal 103 is disposed on the second surface of the first structural member 10, then the through hole 104 penetrating through the first structural member 10 from the first surface to the second surface of the first structural member 10 is disposed, and the first metal layer 105 filled in first through hole 104 is used to implement electrical connection between the qubit 101 and the first connection terminal 103. In this way, it may be ensured that a circuit structure of the qubit 101 and the read cavity 102 is not damaged during fastening of each of the first structural member 10 and the second structural member 20 to the support and connection member 30.

Still referring to FIG. 2, an axial section of the first through hole 104 in a first structure member 10 is trapezoidal in shape. In the present application, when the first through hole 104 is disposed in the first structural member 10, an axial section of the first through hole 104 is trapezoidal in shape. Setting the axial section of the first through hole 104 to be trapezoidal in shape may facilitate fabrication of a conductive layer on a surface of the first through hole 104 by using the atomic deposition technology. Specifically, during conductive layer deposition on the surface of the first through hole 104, metal particles are sprayed onto the surface of the first through hole 104 by using a spray gun. The trapezoidal shape is used, so that the metal particles may be deposited at all positions on the surface of the first through hole 104, and a conductive layer formed after deposition of the metal particles is more uniform.

During disposal of a metal layer on the surface of the first through hole 104, a material of the first metal layer 105 is a superconducting material. A chip prepared in the embodiment of the present application is a superconducting quantum chip. Therefore, during disposal of a conductive structure (namely, the first metal layer 105 on the surface of the first through hole 104, the first connection terminal 103, the support and connection member 30, and the second connection terminal 202) between the qubit 101 and the signal transmission line 201, materials of these components all need to be superconducting materials, so as to meet a power consumption requirement of the superconducting quantum chip.

The superconducting material of the first metal layer 105 is titanium nitride, and a material of the support and connection member 30 is indium. In a specific implementation of the present application, titanium nitride is used. Titanium nitride has high conductivity and high temperature resistance. After the first metal layer 105 of a titanium nitride material is prepared on the surface of the first through hole 104, performance of the first metal layer 105 may be effectively ensured by controlling a processing temperature in a subsequent process of processing a superconducting quantum chip. In addition, the support and connection member 30 is not only configured to support the first structural member 10 and the second structural member 20, but also configured to electrically connect the first connection terminal 103 disposed on the second surface of the first structural member 10 and the second connection terminal 202 disposed on the first surface of the second structural member 20. Thus, a superconducting material is also selected for the support and connection member 30. Steps of preparing the support and connection member 30 includes: generating, by using an electron beam evaporation coating technology, the support and connection member 30 on a surface of the second connection terminal 202 provided on the first surface of the second structural member 20; and fastening the other end of the support and connection member 30 to the first connection terminal 103 of the first structural member 10 by means of welding. In the embodiment of the present application, indium is selected as the material of the support and connection member 30, because a melting point of indium is lower than that of other superconducting materials, so as to facilitate welding and avoiding an impact of high temperature on the first metal layer 105.

In addition, a second metal layer is disposed on the first surface of the second structural member 20. Since materials of the second structural member 20 are all semiconductor materials, when the signal transmission line 201 is in a form of a microstrip transmission line, the signal transmission line 201 cannot be prepared directly on the surface of the second structural member 20. First, one conductive metal layer (namely, a second metal layer) is formed on the first surface of the second structural member 20, and then the signal transmission line 201 is prepared on a surface of the second metal layer by using a patterning process such as photolithography. However, after the signal transmission line 201 is prepared on the second metal layer, the second metal layer except for the signal transmission line 201 needs to be removed, so that only a circuit structure corresponding to the signal transmission line 201 and the second connection terminal 202 is formed on the first surface of the second structural member 20.

In the superconducting quantum chip structure shown in FIG. 2 and FIG. 4, a protective film 107 (namely, a second protective film 107) is filled on a surface of the first metal layer 105. As described above, the first metal layer 105 is a conductive layer prepared on an inner surface of the first through hole 104 by using a metal deposition technology and configured to electrically connect the qubit 101 and the first connection terminals 103. In a processing process of the superconducting quantum chip involved in the embodiment of the present application, the first through hole 104 is first prepared, then the first metal layer 105 is deposited on the inner surface of the first through hole 104, next structures such as the read cavity 102 and the qubit 101 are prepared on the first surface of the first structural member 10, and two ends of the support and connection member 30 are fastened to the first structural member 10 and the second structural member 20 respectively by using a welding technology. It may be found that after a first metal film is deposited on the surface of the first through hole 104, there are a plurality of subsequent processes, and it is even in a high-temperature environment during welding of the support and connection member 30. When one layer of protective film (namely, the second protective film 107) is filled on the surface of the first metal layer 105, the first metal layer 105 may be effectively prevented from being oxidized, falling off, and the like, thereby ensuring conductivity of the first metal layer 105.

As shown in FIG. 2, FIG. 5, and FIG. 6, the support and connection member 30 is cylindrical in shape. Both ends of the support and connection member 30 need to be fastened to the first connection terminal 103 and the second connection terminal 202 respectively by welding, and the first connection terminal 103 is disposed on the second surface of the first structural member 10 and around the first through hole 104. The second connection terminal 202 is formed at a position, corresponding to the first connection terminal 103, on the first surface of the second structural member 20, and both the first connection terminal 103 and the second connection terminal 202 are cylindrical. Therefore, the support and connection member 30 is cylindrical in shape, and contact areas of the support and connection member 30 with the first connection terminal and the second connection terminal 202 are large, so that a welding effect and a conductive effect may be ensured when welding is performed.

Compared with the related art, the superconducting quantum chip structure of the present application includes a first structural member 10, a second structural member 20, and a support and connection member 30. The first structural member 10 is provided with a qubit 101, a read cavity 102, and a first connection terminal 103, where the qubit 101 is coupled to the read cavity 102, and the qubit 101 is electrically connected to the first connection terminal 103; the second structural member 20 is provided with a signal transmission line 201 and a second connection terminal 202 electrically connected to each other; and two ends of the support and connection member 30 are electrically connected to the first connection terminal 103 and the second connection terminal 202, respectively, and the support and connection member is configured to transmit a control signal received on the signal transmission line 201 to the qubit 101. The qubit 101, the read cavity 102, and the signal transmission line 201 are disposed on different structural members, and the qubit 101 disposed on the first structural member 10 and the signal transmission line 201 disposed on the second structural member 20 are electrically connected by means of the first connection terminal 103, the second connection terminal 202, and the support and connection member 30, so that a complete superconducting quantum chip structure is formed, a planar size of the superconducting quantum chip is greatly reduced, and an integration degree of a multi-bit superconducting quantum chip is improved.

The following describes embodiment 3 of a fabrication method for a superconducting quantum chip according to the present application and corresponding to the embodiment 3 of the superconducting quantum chip structure in detail with reference to the accompanying drawings.

As shown in FIG. 18, the step of forming a signal transmission line 201 and a second connection terminal 202 on the second structural member 20 includes the following steps.

Step S201: Forming a second through hole 204 penetrating through the second structural member 20 from a first surface to a second surface of the second structural member 20.

Compared with Step S101 in the method embodiment 1, in this embodiment, the second through hole 204 penetrating through the second structural member 20 from the first surface to the second surface of the second structural member 20 is selected to be formed on the second structural member 20, and the second through hole 204 penetrates the second structural member from the first surface to the second surface of the second structural member 20, thereby facilitating communication between the first surface and the second surface of the second structural member 20. The method for forming the second through hole 204 in the second structural member 20 may also use inductively coupled plasma etching and the method is the same as that for forming the first through hole 104 in the first structural member 10, and details are not described herein.

S202: Filling a second metal layer 203 in the second through hole 204.

A circuit structure on the first surface and a circuit structure on the second surface of the second structural member 20 are electrically connected by filling the second metal layer 203 in the second through hole 204. The method for filling the second metal layer 203 in the second through hole 204 may also use an atomic layer deposition technology, which is the same as the method for forming the first metal layer 105 in the first through hole 104, and details are not described herein. In addition, a material of the metal layer 205 may alternatively be the same as that of the first metal layer 105. In addition, one layer of third protective film 206 is also formed on a surface of the second metal layer 203 by using an atomic layer deposition technology. The forming method and effect of the third protective film 206 are the same as those of the second protective film 107, and details are not described herein again.

Step S203: Forming the second connection terminal 202 on the first surface of the second structural member 20.

The second connection terminal 202 is directly formed on the first surface of the second structural member 20 by using an atomic layer deposition technology. The second connection terminal and the first connection terminal 103 on the first structural member 10 are correspondingly disposed, so that the first connection terminal 103 and the second connection terminal 202 are electrically connected by using the support and connection member 30. In addition, the second connection terminal 203 is distributed on the second surface of the second structural member 20 along a circumferential direction of the second through hole 204, and the second connection terminal 203 is disposed coaxially with the second through hole 204, so that the second connection terminal 203 is electrically connected to the second metal layer 203 filled in the second through hole 204.

Step S204: Forming the signal transmission line 201 on the second surface of the second structural member 20.

A process same as that in Step S112 is used, the third metal layer 205 is first formed on the second surface of the second structural member 20 by using an atomic layer deposition technology, the signal transmission line 201 is formed on the third metal layer 205, and the third metal layer 205 except for the signal transmission line 201 is removed.

The signal transmission line 201 and the second connection terminal 202 may be formed on different surfaces of the second structural member 20. Specifically, the second connection terminal 202 is formed on the first surface of the second structural member 20, the signal transmission line 201 is formed on the second surface of the second structural member 20, and a complete superconducting quantum chip circuit is formed by means of the second through hole 204 penetrating through the second structural member 20 from the first surface to the second surface of the second structural member 20 and electrical connection between the second metal layer 203 filled in the second through hole 204 and the second connection terminal 202.

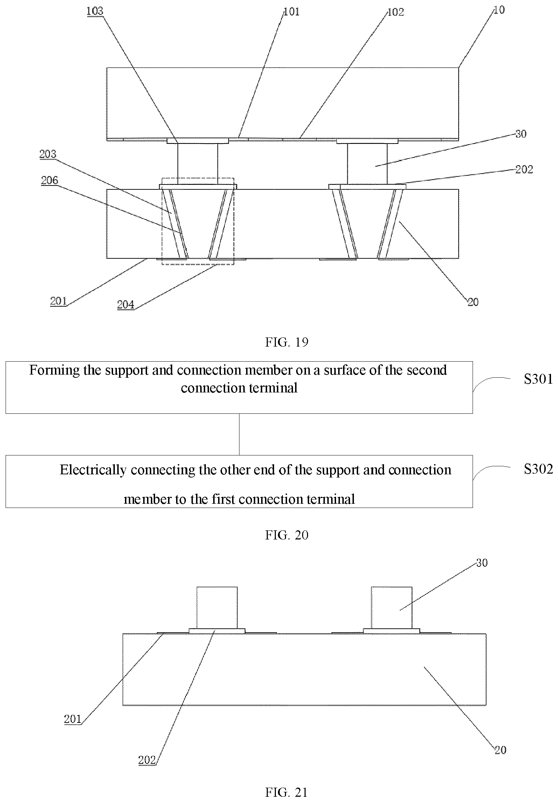

As shown in FIG. 19, in order to prepare the superconducting quantum chip structure according to the method provided in this embodiment, the qubit 101, the read cavity 102, and the first connection terminal 103 are formed on the second surface of the first structural member 10. The second connection terminal 202 is formed on the first surface of the second structural member 20, and the signal transmission line 201 is formed on the second surface of the second structural member 20. In addition, a second through hole 204 penetrating through the second structural member 20 from the first surface to the second surface of the second structural member 20 is formed on the second structural member 20, the second through hole 204 is filled with a second metal layer 203, and the second connection terminal 202 and the signal transmission line 201 are electrically connected through the second metal layer 203.

Compared with the method embodiment 2, in this embodiment, the second connection terminal 202 is formed on the first surface of the second structural member 20 while the signal transmission line 201 is formed on the second surface of the second structural member 20, and the second through hole 204 penetrating through the second structural member 20 from the first surface to the second surface of the second structural member 20 is disposed. In addition, a second metal layer 203 is filled in the second through hole 204, so that the second connection terminal 202 and the signal transmission line 201 are electrically connected by means of conductivity of the second metal layer 203. In this way, a distance between the signal transmission line 201 and the qubit 101 is increased, and crosstalk of a superconducting quantum circuit is weakened to a negligible extent by using an insulating effect of the second structural member 20 itself.

It should be noted that, in the chip fabrication field, especially in the superconducting quantum chip fabrication field, a material of a substrate is generally sapphire, silicon, silicon carbide, or the like, and these materials themselves have an insulating effect. Therefore, in the foregoing three embodiments, the superconducting quantum chip structures in the method embodiment 1 and the method embodiment 3 are preferably selected. The qubit 101 is isolated from the signal transmission lines 201 by using insulating properties of materials of the first structural member 10 and the second structural member 20, and the first structural member 10 is isolated from the second structural member 20 in layers by means of a support and connection member 30, significantly reducing a crosstalk impact of a control signal applied to the signal transmission line 201 on another qubit 101.

More optionally, in the method embodiment 1 and the method embodiment 3, the superconducting quantum chip fabrication method in the method embodiment 1 is preferably selected. That is, the qubit 101 and the read cavity 102 are formed on the first surface of the first structural member 10, the first connection terminal 103 is formed on the second surface of the first structural member 10, the through hole 104 penetrating through the first structural member 10 from the first surface and to second surface of the first structural member 10 is formed, and the first metal layer 105 filled in first through hole 104 is used to implement electrical connection between the qubit 101 and the first connection terminal 103. In this way, a case that a circuit structure of the qubit 101 and the read cavity 102 is damaged during fastening of each of the first structural member 10 and the second structural member 20 to the support and connection member 30 may be avoided.

According to the foregoing steps, the qubit 101, the read cavity 102, and the first connection terminal 103 are formed on the first structural member 10, and the signal transmission line 201 and the second connection terminal 202 are formed on the second structural member 20, so that the step of forming the support and connection member may be performed.

As shown in FIG. 20, the step of forming a support and connection member, where two ends of the support and connection member are electrically connected to the first connection terminal 103 and the second connection terminal 202 respectively includes:
Step S301: forming the support and connection member 30 on a surface of the second connection terminal 202; and
Step S302: electrically connecting the other end of the support and connection member 30 to the first connection terminal 103.

Specifically, the support and connection member 30 may be formed on a surface of the first connection terminal 103 or on a surface of the second connection terminal 202 by using an atomic layer deposition technology, or the support and connection member 30 may be separately formed.

In contrast, since the qubit 101 and the read cavity 102 need to be formed on the first surface of the first structural member 10, when the support and connection member 30 is formed by using an atomic layer deposition technology on the surface of the second connection terminal 202 located on the second surface of the first structural member 10, a circuit structure of the qubit 101 and the read cavity 102 that are on the first surface is easily damaged. In addition, after the support and connection member 30 is separately formed, it is difficult to fasten the support and connection member 30 to each of the first structural member 10 and the second structural member 20, and alignment and welding processes are difficult to be ensured during fastening and welding. Therefore, in the present application, the support and connection member 30 is preferably formed on a surface of the second connection terminal 202.

As shown in FIG. 21, after the signal transmission line 201 and the second connection terminal 202 are formed on the first surface of the second structural member 20, a pattern of the support and connection member 30 is formed on a surface of the second connection terminal 202 by using an ultraviolet photolithography process, and metal particles are filled in the pattern of the support and connection member 30 by using electron beam evaporation coating technology to form a fourth cylindrical metal layer (namely, the support and connection member 30) having a predetermined size.

The support and connection member 30 may not only be configured to support the first structural member 10 and the second structural member 20, but also be configured to electrically connect the first connection terminal 103 disposed on the second surface of the first structural member 10 and the second connection terminal 202 disposed on the first surface of the second structural member 20. Thus, a superconducting material may also be selected for the support and connection member 30.

In Step S301, the support and connection member 30 is directly formed on the surface of the second connection terminal 202, that is, one end of the support and connection member 30 is electrically connected to the second connection terminal 202, and the other end of the support and connection member 30 is electrically connected to the first connection terminal 103. The support and connection member 30 may not only support the first structure and the second structure, but also electrically connect the first structure and the second structural member 20, so that the circuit structure (namely, the qubit 101, the read cavity 102, and the signal transmission line 201) of the superconducting quantum chip is connected, thereby forming a complete superconducting quantum circuit.

The step of electrically connecting the other end of the support and connection member 30 to the first connection terminal 103 may include: fastening the other end of the support and connection member 30 to the first connection terminal 103 by using a flip-chip bonding technology.

The support and connection member 30 is formed by using an electron beam evaporation coating technology, and is formed on a surface of the second connection terminal 202 disposed on the first surface of the second structural member 20. In addition, the other end of the support and connection member 30 also needs to be fastened to the first connection terminal 103 of the first structural member 10 by means of flip-chip welding. In the present application, indium is selected as the material of the support and connection member 30, because a melting point of indium is lower than that of other superconducting materials, so as to facilitate welding and avoiding an impact of high temperature on the first metal layer 105.

In addition, not only the other end of the support and connection member 30 needs to be fastened to the first connection terminal 103 by welding, but also the surface on which the support and connection member 30 contacts the second connection terminal 202 needs to be fastened to the support and connection member 30 by mean of flip-chip welding. The support and connection member 30 is formed in a cylindrical shape and fits a shape of the first connection terminal 103 disposed around the first through hole 104 to ensure that the support and connection member 30, the first connection terminal 103, and the second connection terminal 202 are coaxially provided, so that alignment of the first connection terminal 103, the second connection terminal 202, and the first through hole 104 is easily implemented during fastening and welding.

In addition, the first connection terminal 103 is disposed on the second surface of the first structural member 10 and around the first through hole 104, the second connection terminal 202 is formed at a position, corresponding to the first connection terminal 103, on the first surface of the second structural member 20, and both the first connection terminal 103 and the second connection terminal 202 are cylindrical. Therefore, the support and connection member 30 is cylindrical in shape, and contact areas of the support and connection member 30 with the first connection terminal and the second connection terminal 202 are large, so that a welding effect and a conductive effect may be ensured when welding is performed. Thus, consistency of circuits of all qubits 101 on the superconducting quantum chip is ensured.

In the present application, a qubit 101 and a read cavity 102 are formed on a first structural member 10, and a signal transmission line 201 is formed on a second structural member 20; a circuit structure (the qubit 101 and the read cavity 102) of a superconducting quantum chip for implementing quantum computing and a signal transmission line 201 for implementing control and regulation of the qubit 101 are layered and separately formed; and a first connection terminal 103 electrically connected to the qubit 101 is formed on the first structural member 10 and a second connection terminal 202 electrically connected to the signal transmission line 201 is formed on the second structural member 20, and a support and connection member 30 is used to electrically connect the first connection terminal 103 and the second connection terminal 202, thereby forming a complete circuit structure of a superconducting quantum chip. The superconducting quantum chip prepared by using the method in the present application has a high integration degree.

The constructions, features, and functions of the present application are described in detail in the embodiments with reference to the accompanying drawings. The foregoing is merely preferred embodiments of the present application, and the present application is not limited by the accompanying drawings. All equivalent embodiments that are modified or changed according to the concept of the present application and do not depart from the spirit of the description and the drawings should fall within the protection scope of the present application.

### INDUSTRIAL APPLICABILITY

The present application provides a superconducting quantum chip structure and a fabrication method for a superconducting quantum chip. The superconducting quantum chip structure includes a first structural member, a second structural member, and a support and connection member, where the first structural member is provided with a qubit, a read cavity and a first connection terminal, the qubit is coupled to the read cavity and the qubit is electrically connected to the first connection terminal; the second structural member is provided with a signal transmission line and a second connection terminal electrically connected to each other; and two ends of the support and connection member are electrically connected to the first connection terminal and the second connection terminal, respectively, and the support and connection member is configured to transmit a control signal received on the signal transmission line to the qubit. According to the technical solutions of the present application, a planar size of a superconducting quantum chip structure is reduced, and an integration degree of a multi-bit superconducting quantum chip is improved.

In addition, it may be understood that, the superconducting quantum chip structure and the fabrication method for a superconducting quantum chip in the present application may be reproduced, and may be used in various industrial applications. For example, the superconducting quantum chip structure and the fabrication method for a superconducting quantum chip in the present application may be used in the field of quantum computing and chip fabrication technologies.

## Claims

1. A superconducting quantum chip structure, comprising a first structural member, a second structural member, and a support and connection member, wherein
the first structural member is provided with a qubit, a read cavity, and a first connection terminal, the qubit is coupled to the read cavity, and the qubit is electrically connected to the first connection terminal;
the second structural member is provided with a signal transmission line and a second connection terminal electrically connected to each other; and
two ends of the support and connection member are electrically connected to the first connection terminal and the second connection terminal, respectively, and the support and connection member is configured to transmit a control signal received on the signal transmission line (201) to the qubit.

2. The superconducting quantum chip structure according to claim 1, wherein the qubit and the read cavity are located on a first surface of the first structural member, the first connection terminal is located on a second surface of the first structural member, the first structural member is further provided with a first through hole penetrating through the first structural member from the first surface to the second surface, the first through hole is filled with a first metal layer, and the first metal layer is configured to electrically connect the qubit and the first connection terminal.

3. The superconducting quantum chip structure according to claim 2, wherein the first connection terminal is distributed on the second surface of the first structural member along a circumferential direction of the first through hole and is coaxial with the first through hole.

4. The superconducting quantum chip structure according to any one of claims 1 to 3, wherein the qubit, the read cavity, and the first connection terminal are all located on the second surface of the first structural member, the signal transmission line (201) and the second connection terminal are located on a first surface of the second structural member, and the second surface of the first structural member is disposed opposite to the first surface of the second structural member.

5. The superconducting quantum chip structure according to any one of claims 1 to 3, wherein the qubit, the read cavity, and the first connection terminal are all located on a second surface of the first structural member, the second connection terminal is located on a first surface of the second structural member, the signal transmission line is located on a second surface of the second structural member and the second structural member is provided with a second through hole penetrating through the second structural member from the first surface to the second surface of the second structural member, the second through hole is filled with a first metal layer, and the first metal layer is configured to electrically connect the second connection terminal and the signal transmission line (201).

6. The superconducting quantum chip structure according to any one of claim 2 or 5, wherein axial sections of the first through hole and the second through hole are trapezoidal in shape.

7. The superconducting quantum chip structure according to claim 2 or 5, wherein the first metal layer is made of a superconducting material.

8. The superconducting quantum chip structure according to claim 7, wherein the superconducting material is titanium nitride, and the support and connection member is made of indium.

9. The superconducting quantum chip structure according to claim 2 or 5, wherein a surface of the first metal layer is filled with a protective film.

10. The superconducting quantum chip structure according to any one of claims 1 to 9, wherein the support and connection member is cylindrical in shape.

11. A fabrication method for a superconducting quantum chip, comprising:
forming a qubit, a read cavity, and a first connection terminal on a first structural member, wherein the qubit is coupled to the read cavity, and the qubit is electrically connected to the first connection terminal;
forming a signal transmission line (201) and a second connection terminal on a second structural member, wherein the signal transmission line (201) and the second connection terminal are electrically connected; and
forming a support and connection member, wherein two ends of the support and connection member are electrically connected to the first connection terminal and the second connection terminal, respectively, and the support and connection member is configured to transmit a control signal received on the signal transmission line (201) to the qubit.

12. The fabrication method for a superconducting quantum chip according to claim 11, wherein the step of forming a qubit, a read cavity, and a first connection terminal on the first structural member comprises:
forming a first through hole penetrating through the first structural member from a first surface to a second surface of the first structural member;
filling a first metal layer in the first through hole;
forming the first connection terminal on the second surface of the first structural member; and
forming the qubit and the read cavity on the first surface of the first structural member, wherein
the first metal layer is configured to electrically connect the qubit and the first connection terminal.

13. The fabrication method for a superconducting quantum chip according to claim 12, wherein before the step of forming a first through hole penetrating through the first structural member from a first surface to a second surface of the first structural member, the fabrication method comprises:
forming a first protective film on the second surface of the first structural member.

14. The fabrication method for a superconducting quantum chip according to claim 12 or 13, wherein the step of forming a first through hole penetrating through the first structural member from a first surface to a second surface of the first structural member comprises:
performing etching on the first structural member by using an inductively coupled plasma to form the first through hole.

15. The fabrication method for a superconducting quantum chip according to any one of claims 12 to 14, wherein the step of filling a first metal layer in the first through hole comprises:
forming the first metal layer in the first through hole by using an atomic layer deposition technology.

16. The fabrication method for a superconducting quantum chip according to claim 15, wherein after the step of forming the first metal layer in the first through hole by using an atomic layer deposition technology, the fabrication method comprises:
forming a second protective film (107) on a surface of the first metal layer (104).

17. The fabrication method for a superconducting quantum chip according to any one of claims 11 to 16, wherein the step of forming a qubit, a read cavity, and a first connection terminal on the first structural member comprises: forming the qubit, the read cavity, and the first connection terminal on the second surface of the first structural member; and
the step of forming a signal transmission line (201) and a second connection terminal on a second structural member comprises: forming the signal transmission line (201) and the second connection terminal on a first surface of the second structural member, wherein the second surface of the first structure is disposed opposite to the first surface of the second structure.

18. The fabrication method for a superconducting quantum chip according to any one of claims 11 to 16, wherein the step of forming a signal transmission line (201) and a second connection terminal on a second structural member comprises:
forming a second through hole penetrating through the second structural member from the first surface to a second surface of the second structural member;
filling a second metal layer in the second through hole;
forming the second connection terminal on the first surface of the second structural member; and
forming the signal transmission line (201) on the second surface of the second structural member, wherein
the second metal layer is configured to electrically connect the signal transmission line (201) and the second connection terminal.

19. The fabrication method for a superconducting quantum chip according to any one of claims 11 to 18, wherein the step of forming a support and connection member, wherein two ends of the support and connection member are electrically connected to the first connection terminal and the second connection terminal, respectively comprises:
forming the support and connection member on a surface of the second connection terminal; and
electrically connecting the other end of the support and connection member to the first connection terminal.

20. The fabrication method for a superconducting quantum chip according to claim 19, wherein the step of electrically connecting the other end of the support and connection member to the first connection terminal comprises:
welding the other end of the support and connection member to the first connection terminal by using a flip-chip bonding technology.
